# DEMANDE DE BREVET EUROPEEN

(11) **EP 4 451 493 A1**
(43) Date de publication de la demande: **23.10.2024**
(21) Numéro de dépôt: 24166486.1
(22) Date de dépôt: 26.03.2024
(51) Int. Cl.: H02H 3/16, H02H 5/12, H02H 3/50

(54) **SYSTÈME DE PROTECTION D'UN CIRCUIT ÉLECTRIQUE POUR UN AÉRONEF**

(30) Priorité: 31.03.2023 FR 2303146
(71) Demandeur: Airbus Opérations SAS, 31060 Toulouse Cedex 09 (FR)
(72) Inventeur: ALLIAS, Jean-François, 31060 TOULOUSE (FR); CARPENTIER, Florian, 31700 BLAGNAC (FR)
(74) Mandataire: Cabinet Le Guen Maillet

(57) **Abrégé**

L'invention propose un système de protection électrique (100) d'un circuit électrique (10) comportant un générateur (G) et une pluralité d'appareils électriques, chaque appareil (15) comportant un châssis. Le système de protection (100) comporte une première liaison (11) associée à chaque appareil (15), reliant le châssis dudit appareil (15) à une terre (14), et comportant une résistance de protection (111). Pour au moins un des appareils électriques (15) fonctionnant en courant continu, la première liaison électrique (11) associée comporte un condensateur de protection (113) en parallèle de la résistance de protection (111). Le système de protection (100) comporte une deuxième liaison (12) reliant un point neutre du générateur (G) à la terre (14). Ainsi, le système de protection électrique permet de supporter un défaut d'isolement ou plus survenant dans le circuit électrique.

## Description

### DOMAINE TECHNIQUE

La présente invention concerne le domaine de la protection des installations électriques et concerne plus particulièrement un système de protection d'un circuit électrique d'un aéronef.

### ETAT DE LA TECHNIQUE ANTERIEURE

Une installation électrique présente un risque pour le matériel et la continuité de service lorsqu'une partie de l'installation qui n'est pas censée être alimentée et qui est potentiellement conductrice se retrouve en contact avec un potentiel électrique non nul. C'est ce que l'on appelle un défaut d'isolement. Afin de prévenir un tel risque, des schémas de liaison à la terre, également appelés régime de neutre, permettent de définir comment raccorder un point neutre d'une source d'alimentation électrique d'une part, et tout châssis d'un appareil électrique de l'installation électrique, autrement dit toute partie potentiellement conductrice et non alimentée électriquement, d'autre part, à une référence de potentiel tel qu'une terre.

Le régime de neutre appelé « IT » présente un raccordement du point neutre de la source d'alimentation de manière impédante par rapport à la terre, autrement dit par le biais d'une impédance ou résistance, et présente un raccordement de chaque châssis d'appareil électrique à la terre. Le régime de neutre « IT » permet de supporter un défaut d'isolement dans un circuit électrique. Lorsqu'une tension non nulle résultant du défaut d'isolement survient entre une borne de la source d'alimentation et le point neutre de la source d'alimentation, cela génère un courant de défaut relativement faible car inversement proportionnel à la résistance située entre le point neutre de la source d'alimentation et la terre. Le courant de défaut est ainsi supportable par le circuit électrique et le matériel.

En revanche, le régime de neutre « IT » ne permet pas de supporter plus d'un défaut d'isolement dans le circuit électrique. Lorsqu'un deuxième défaut d'isolement survient, le courant de défaut devient élevé car il circule par le chemin le moins impédant et ne passe donc plus par le point neutre de la source d'alimentation et la résistance mais par chacun des deux défauts d'isolement, pouvant ainsi créer un court-circuit.

Un contrôleur permanent d'isolement CPI (ou IMD pour « insulation monitor device » en anglais) peut être utilisé pour détecter des défauts d'isolement dès leur apparition par exemple par comparaison d'un courant de défaut à un seuil de détection, ce qui permet ainsi d'intervenir pour réparer un premier défaut d'isolement avant qu'un deuxième défaut d'isolement ne survienne. En outre, le contrôleur permanent d'isolement est utilisé conjointement avec un dispositif de sécurité tel qu'un fusible, de sorte que le contrôleur permanent d'isolement déclenche le dispositif de protection dès qu'un deuxième défaut survient, entraînant alors l'arrêt de l'alimentation électrique dans le circuit électrique, ce qui permet de protéger le matériel mais nuit à la continuité de service.

Par un abus de langage largement répandu, on emploie parfois, dans la présente description, le terme « capacité » pour désigner un « condensateur ». En d'autres termes, dans un souci de simplification, on confond parfois le terme « condensateur », qui désigne un composant, avec le terme « capacité », qui désigne la capacité électrique qui caractérise ce composant.

Toutefois, la présence de certaines capacités (i.e. condensateurs) dans le circuit électrique, et notamment de capacités inévitables telles que des capacités de mode commun ou capacités parasites, peut entraîner le passage de signaux alternatifs par la terre et déclencher alors une détection de défaut d'isolement par le contrôleur de défaut d'isolement, même en l'absence d'un tel défaut d'isolement. Le diagnostic est alors faussé et peut entraîner l'arrêt de l'alimentation électrique dans le circuit électrique par déclenchement du dispositif de protection, même lorsque le nombre réel de défauts d'isolement est inférieur à deux et ne le nécessite pas. Par ailleurs, le seuil de détection peut être difficile à déterminer car les courants générés par les capacités parasites peuvent varier, en particulier lorsque la puissance délivrée par la source d'alimentation varie.

En outre, la présence dans le circuit électrique de capacités peut empêcher le régime de neutre « IT » à supporter un unique défaut d'isolement. C'est le cas par exemple lorsqu'un circuit électrique comporte des appareils électriques fonctionnant en courant continu et des appareils électriques fonctionnant en courant alternatif. Un défaut d'isolement au niveau d'un appareil fonctionnant en courant alternatif entraîne l'introduction par la terre d'un signal alternatif. Un tel signal alternatif est donc transmis à une capacité reliant l'une des bornes de la source d'alimentation à un châssis d'un autre appareil électrique. Lorsque le niveau de tension du signal alternatif est élevé, la capacité peut ne pas être en mesure de gérer la tension alternative et est alors détruite. Lorsque le niveau de tension est plus faible, la capacité en question laisse passer une composante alternative qui peut se retrouver dans une partie du circuit électrique fonctionnant en courant continu, entraînant la destruction d'appareils électriques ou de matériel présents sur ladite partie du circuit électrique.

Or, de telles capacités peuvent être inévitables ou nécessaires. Par exemple, certaines capacités parasites résultent de la configuration du circuit électrique et sont inévitables. De telles capacités parasites sont formées par une interaction, à travers un isolant, entre deux conducteurs positionnés parallèlement, tels qu'un fil conducteur d'un câble, un autre fil du même câble, un blindage du câble ou encore un conducteur d'équipotentialité utilisé comme terre. En outre, les effets des capacités parasites sont d'autant plus élevés que la puissance délivrée par le circuit électrique est élevée. Selon un autre exemple, certaines capacités de filtrage sont nécessaires car elles permettent de filtrer des composantes alternatives de courant à des fréquences définies, pour les envoyer vers la terre afin de limiter le bruit d'un signal électrique et ainsi augmenter la durée de vie de composants électriques par lesquels passe ledit signal.

Dans le contexte d'un circuit électrique d'un aéronef, il est nécessaire de pouvoir supporter au moins un défaut d'isolement dans un circuit électrique afin de maintenir l'alimentation électrique même lorsqu'un défaut d'isolement survient, en particulier dans le cas de moteurs de propulsion alimentés électriquement. Cela est d'autant plus vrai que certaines fonctions nécessaires à la génération d'électricité par des sources d'alimentation de type piles à combustible, telles que des fonctions de refroidissement ou d'acheminement de dihydrogène ou de dioxygène, sont mutualisées pour plusieurs moteurs électriques.

De plus, un circuit électrique d'un aéronef n'est généralement pas visible ni facilement accessible pour diagnostiquer la présence de défauts d'isolement et effectuer de la maintenance.

Il est alors souhaitable de pallier ces inconvénients de l'état de la technique.

Il est notamment souhaitable de fournir une solution qui permette de supporter au moins un défaut d'isolement, même lorsque des capacités, inévitables ou nécessaires, sont présentes dans le circuit électrique. Il est en outre souhaitable de fournir une solution qui permette de supporter plusieurs défauts d'isolement. Il est enfin souhaitable de fournir une solution qui permette de détecter aisément, et à distance, la présence et la localisation de défauts d'isolement.

### EXPOSE DE L'INVENTION

Un objet de la présente invention est de proposer un système de protection électrique d'un circuit électrique d'un aéronef. Le circuit électrique comporte : un générateur et une pluralité d'appareils électriques, chaque appareil électrique comportant un châssis. Le système de protection électrique comporte : une première liaison électrique associée à chaque appareil électrique, chaque première liaison électrique reliant le châssis dudit appareil électrique à une terre, chaque première liaison électrique comportant une résistance, dite résistance de protection ; et une deuxième liaison électrique reliant un point neutre du générateur à la terre. En outre, pour au moins un des appareils électriques fonctionnant en courant continu, la première liaison électrique associée comporte un condensateur, dit condensateur de protection, en parallèle de la résistance de protection.

Ainsi, le système de protection électrique permet de supporter un défaut d'isolement ou plus survenant dans le circuit électrique, même lorsque des capacités parasites ou de filtrage sont présentes dans le circuit électrique. En d'autres termes, le système de protection électrique permet une continuité de fonctionnement du circuit électrique en cas de défaut d'isolement. Pour le au moins un appareil électrique fonctionnant en courant continu, le fait que la première liaison électrique (qui relie le châssis de l'appareil électrique à la terre) comporte un condensateur de protection en parallèle d'une résistance de protection permet, en cas de défaut d'isolement :
- que la résistance de protection écoule à la terre la composante continue d'un courant de défaut, ce qui évite que cette composante continue dégrade la charge électrique de l'appareil électrique et garantit la sécurité des personnes ; en outre la résistance de protection permet de limiter le courant de défaut, ce qui permet de limiter le courant dans les câbles alimentant la charge électrique et donc d'éviter leur endommagement et de permettre la continuité de fonctionnement de l'appareil électrique ; et
- que le condensateur de protection laisse passer et écoule à la terre la ou les composantes alternatives du courant (ces composantes alternatives, aussi appelées « courants d'harmoniques » ou tout simplement « harmoniques », correspondent à des courants de mode commun (courants alternatifs issus de commutations d'onduleurs ou autres, bruits rayonnés par d'autres charges et captés par effet antenne, etc.)), ce qui évite que cette ou ces composantes alternatives dégradent la charge électrique de l'appareil électrique qui fonctionne en courant continu.

Selon un mode de réalisation particulier, pour au moins un des appareils électriques fonctionnant en courant alternatif, la première liaison électrique associée comporte uniquement la résistance de protection, sans condensateur de protection en parallèle.

Selon un mode de réalisation particulier, le circuit électrique comporte en outre au moins un câble blindé comportant un blindage et reliant au moins un appareil électrique aux bornes du générateur. Le système de protection électrique comporte en outre une première liaison électrique associée à chaque câble blindé, ladite première liaison électrique reliant le blindage du câble blindé à la terre et comportant une résistance de protection et un condensateur de protection en parallèle de la résistance de protection.

Selon un mode de réalisation particulier, le système de protection électrique comporte en outre :
- au moins un détecteur de tension, chaque détecteur de tension étant associé à une première liaison électrique et étant configuré pour effectuer une mesure de tension aux bornes de la résistance de protection de ladite première liaison électrique, et
- un contrôleur de défauts configuré, pour chaque détecteur de tension, pour :
   ∘ recevoir une mesure de tension en provenance du détecteur de tension, et
   ∘ transmettre une information représentative d'un défaut d'isolement sur l'appareil électrique associé à la première liaison électrique qui est associée au détecteur de tension lorsque la mesure de tension dépasse un seuil de tension prédéfini.

Selon un mode de réalisation particulier, le système comporte en outre un détecteur de courant configuré pour effectuer une mesure de courant circulant par la deuxième liaison électrique. Le contrôleur de défauts est configuré en outre pour : recevoir la mesure de courant en provenance du détecteur de courant ; et transmettre une information représentative d'un défaut d'isolement dans le circuit électrique lorsque la mesure de courant dépasse un seuil de courant prédéfini.

Selon un mode de réalisation particulier, chaque résistance de protection a une valeur comprise entre 1 kΩ et 10 kΩ.

Selon un mode de réalisation particulier, le générateur génère un courant continu et la pluralité d'appareils comporte au moins un moteur fonctionnant en courant alternatif et un onduleur situé entre le générateur et ledit moteur.

Selon un mode de réalisation particulier, le générateur est un ensemble de piles à combustible.

L'invention concerne également un aéronef comportant un tel système de protection électrique.

L'invention concerne également un procédé destiné à détecter un défaut d'isolement dans un circuit électrique, le circuit électrique comportant : un générateur et une pluralité d'appareils électriques, chaque appareil électrique comportant un châssis. Le circuit électrique comporte en outre un système de protection électrique comportant : une première liaison électrique associée à chaque appareil électrique, chaque première liaison électrique reliant le châssis dudit appareil électrique à une terre et comportant une résistance, dite résistance de protection ; pour au moins un des appareils électriques fonctionnant en courant continu, la première liaison électrique associée comporte un condensateur, dit condensateur de protection, en parallèle de la résistance de protection ; une deuxième liaison électrique reliant un point neutre du générateur à la terre ; et au moins un détecteur de tension, chaque détecteur de tension étant associé à une première liaison électrique et étant configuré pour effectuer une mesure de tension aux bornes de la résistance de protection de la première liaison électrique. Le procédé est implémenté par un contrôleur de défauts et comporte, pour chaque détecteur de tension, des étapes de : recevoir une mesure de tension en provenance du détecteur de tension ; et transmettre une information représentative d'un défaut d'isolement sur l'appareil électrique associé à la première liaison électrique qui est associée au détecteur de tension lorsque la tension mesurée dépasse un seuil de tension prédéfini.

Selon un mode de réalisation particulier, le système de protection électrique comporte en outre un détecteur de courant configuré pour effectuer une mesure de courant circulant par la deuxième liaison électrique, et le procédé comporte en outre des étapes de : recevoir la mesure de courant en provenance du détecteur de courant ; et transmettre une information représentative d'un défaut d'isolement dans le circuit électrique lorsque le courant mesuré dépasse un seuil de courant prédéfini.

### BREVE DESCRIPTION DES DESSINS

Les caractéristiques de l'invention mentionnées ci-dessus, ainsi que d'autres, apparaîtront plus clairement à la lecture de la description suivante d'au moins un exemple de réalisation, ladite description étant faite en relation avec les dessins joints, parmi lesquels :
[Fig. 1] illustre schématiquement un circuit électrique comportant un système de protection électrique selon un premier mode de réalisation ;
[Fig. 2A] illustre schématiquement un appareil électrique selon un premier mode de réalisation ;
[Fig. 2B] illustre schématiquement un appareil électrique selon un deuxième mode de réalisation ;
[Fig. 2C] illustre schématiquement un appareil électrique selon un troisième mode de réalisation ;
[Fig. 3] illustre schématiquement un aéronef qui comporte au moins un circuit électrique comportant le système de protection électrique.
[Fig. 4] illustre schématiquement le circuit électrique comportant le système de protection électrique, selon un deuxième mode de réalisation.
[Fig. 5] illustre schématiquement le circuit électrique comportant le système de protection électrique, selon un troisième mode de réalisation.
[Fig. 6] illustre schématiquement un exemple de plateforme matérielle permettant d'implémenter, sous forme de circuiterie électronique, un contrôleur de défauts.
[Fig. 7] illustre schématiquement un procédé de détection d'un défaut d'isolement, selon un premier mode de réalisation, implémenté par le contrôleur de défauts ; et
[Fig. 8] illustre schématiquement un procédé de détection d'un défaut d'isolement, selon un deuxième mode de réalisation, implémenté par le contrôleur de défauts.

### EXPOSE DETAILLE DE MODES DE REALISATION

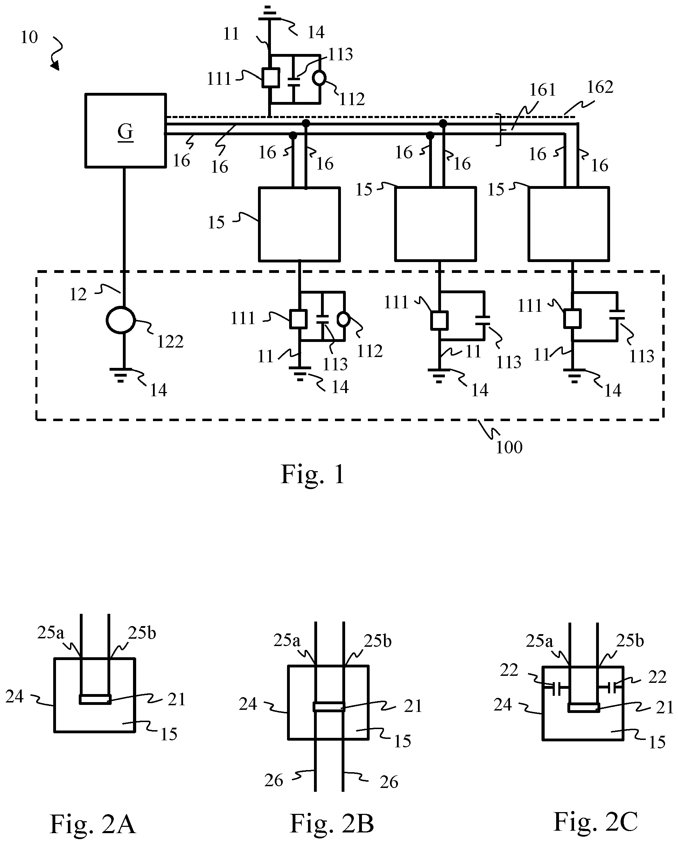

La Fig. 1 illustre ainsi schématiquement un circuit électrique 10 comportant un système de protection électrique 100, selon un premier mode de réalisation.

Le circuit électrique 10 comporte un générateur G configuré pour fournir de l'énergie électrique.

Le circuit électrique 10 comporte en outre une pluralité d'appareils électriques 15. Les Figs. 2A, 2B et 2C illustrent schématiquement et de manière plus détaillée un appareil électrique 15 de ladite pluralité d'appareils électriques 15. L'appareil électrique 15 comporte une charge électrique 21 et un châssis 24. Le châssis 24 de l'appareil électrique 15 est une partie conductrice de l'appareil électrique 15 qui n'est normalement pas sous tension, autrement dit qui n'est pas reliée volontairement, par une liaison électrique, à un potentiel non nul. Le châssis 24 de l'appareil électrique 15 est par exemple une carcasse métallique extérieure de l'appareil électrique 15. La charge électrique 21 est un composant électrique, tel qu'un dipôle ou un tripôle, ou une pluralité de composants électriques reliés entre eux, et permettant d'assurer une fonction électrique. Alternativement, la charge électrique 21 est un convertisseur, comme illustré à la Fig. 2B, ou un moteur fonctionnant par exemple en triphasé, en hexaphasé ou en dodécaphasé.

Selon un premier mode de réalisation illustré en Fig. 2A, l'appareil électrique 15 comporte un pôle positif 25a et un pôle négatif 25b, auxquels est reliée la charge électrique 21. Alternativement, l'appareil électrique 15 comporte trois entrées reliées à la charge électrique 21, par exemple lorsque la charge électrique 21 est un tripôle tel qu'un transistor. L'appareil électrique 15 comporte également trois entrées lorsqu'il s'agit d'un moteur triphasé.

Selon un deuxième mode de réalisation illustré en Fig. 2B, l'appareil électrique 15 est un convertisseur, tel qu'un convertisseur continu-continu, capable de modifier une tension, un onduleur, capable de délivrer une tension et un courant alternatifs à partir d'une source d'énergie électrique continue, un transformateur ou un redresseur. Le convertisseur est alors relié d'une part au générateur G par le biais des pôles 25a et 25b et d'autre part à au moins un appareil électrique 15 par le biais de sorties 26. Les sorties 26 sont au nombre de deux. Alternativement, les sorties 26 sont au nombre de trois ou plus lorsque le convertisseur est dédié à l'alimentation d'un appareil électrique 15 fonctionnant avec un nombre de phases supérieur ou égal à trois, tel qu'un moteur triphasé, hexaphasé ou dodécaphasé.

Selon un troisième mode de réalisation illustré à la Fig. 2C, l'appareil électrique 15 comporte en outre des capacités de filtrage 22 situées chacune sur une liaison électrique reliant l'un des pôles 25a, 25b au châssis 24. Les capacités de filtrage 22 permettent de filtrer des composantes alternatives de courant non désirées en les transmettant vers le châssis 24, évitant ainsi que lesdites composantes alternatives endommagent ou détériorent les performances de la charge électrique 21. Les capacités de filtrage 22 sont représentées sur un appareil électrique 15 tel qu'illustré à la Fig. 2A mais peuvent également être présentes dans un appareil électrique 15 de type convertisseur tel que représenté en Fig. 2B.

En se référant à nouveau à la Fig. 1, les châssis 24 d'appareils électriques 15 distincts ne sont pas connectés entre eux.

Le circuit électrique 10 comporte en outre des liaisons électriques schématisées dans les figures par des lignes continues. Le circuit électrique 10 comporte ainsi des liaisons électriques dites liaisons d'alimentation 16 permettant de relier électriquement le générateur G à chaque appareil électrique 15. Les liaisons d'alimentation 16 permettent de faire circuler le courant depuis une première borne du générateur G vers une deuxième borne du générateur G en passant par chaque appareil électrique 15. Un appareil électrique 15 est relié aux bornes du générateur G soit directement, autrement dit uniquement par le biais de liaisons d'alimentation 16, soit par le biais d'au moins un autre appareil électrique 15 assurant un rôle de convertisseur. Les connexions électriques entre deux liaisons d'alimentation 16 sont schématisées dans les figures par des points.

Une liaison d'alimentation 16 peut être physiquement matérialisée par un câble tel qu'un câble blindé 161, comportant deux liaisons d'alimentation 16 permettant de faire circuler le courant dans deux sens opposés et comportant un blindage 162, représenté dans les figures par une ligne discontinue. Dans un mode de réalisation particulier, le circuit électrique 10 comporte ainsi au moins un câble blindé 161.

Le système de protection électrique 100 du circuit électrique 10 est destiné à protéger le circuit électrique 10 lorsqu'un défaut d'isolement survient, autrement dit lorsqu'une liaison électrique, reliée électriquement à l'une des bornes du générateur G, vient à être en contact avec le châssis 24 d'un appareil électrique 15.

Le système de protection électrique 100 comporte, pour chaque appareil électrique 15, une première liaison électrique 11 reliant le châssis 24 dudit appareil électrique 15 à une terre 14, la terre 14 étant une référence de potentiel du circuit électrique 10. En outre, le système de protection électrique 100 comporte une résistance, dite résistance de protection 111, située sur chaque première liaison électrique 11, entre le châssis 24 de l'appareil électrique 15 et la terre 14.

Selon un mode de réalisation, la valeur de la résistance de protection 111 est dimensionnée en fonction d'un nombre d'appareils électriques 15 du circuit électrique 10 et/ou en fonction d'un nombre de défauts d'isolement que le système de protection 100 doit supporter. Plus la valeur de la résistance de protection 111 est élevée, plus le nombre de défauts d'isolement pouvant être supportés est élevé.

Selon un autre mode de réalisation, la valeur de la résistance de protection 111 est dimensionnée en fonction de la valeur maximale de courant de défaut que l'on s'autorise (en particulier pour limiter l'échauffement dans les câbles (liaisons 16) d'alimentation de la charge électrique 21). Par exemple, pour un réseau (circuit électrique) dont la tension d'alimentation est de l'ordre de 800V à 1000V, la résistance de protection 111 peut être choisie égale à environ 1 kΩ pour limiter un courant de défaut à 1A. Une résistance de 10 kΩ permet de limiter le courant à 0,1A. Une valeur de résistance choisie dans l'intervalle 1 kΩ à 10 kΩ peut ainsi convenir dans de nombreuses situations.

La valeur de la résistance de protection 111 peut être la même pour chaque première liaison électrique 11 ou peut différer selon la première liaison électrique 11 considérée. Par exemple, la résistance de protection 111 d'une première liaison électrique 11 associée à un appareil électrique 15 est dimensionnée avec une valeur d'autant plus élevée que l'appareil électrique 15 en question est fragile. Selon un autre exemple, la résistance de protection 111 est plus élevée pour les charges de faible puissance qui nécessitent un courant d'alimentation moindre. La résistance de protection 111 est par exemple dimensionnée pour garder le ratio entre le courant nominal de la charge et le courant de défaut dans un intervalle déterminé, acceptable pour l'échauffement des câbles en cas de défaut.

Ainsi, chaque résistance de protection 111 permet de supporter efficacement au moins un défaut d'isolement en limitant le courant circulant par la terre 14, ledit courant étant inversement proportionnel à la valeur de la résistance de protection 111.

Pour au moins un des appareils électriques 15 fonctionnant en courant continu (et préférentiellement pour chacun), la première liaison électrique 11 associée comporte en outre un condensateur, dit condensateur de protection 113, en parallèle de la résistance de protection 111. Ainsi, dans l'exemple de la Fig. 1, on suppose que tous les appareils électriques 15 fonctionnent en courant continu, et pour chacun la première liaison électrique 11 associée comporte un condensateur de protection 113 en parallèle de la résistance de protection 111.

Le condensateur de protection 113 est par exemple dimensionné pour tenir à la tension du réseau (circuit électrique 10), par exemple 800V. En général, les courants d'harmoniques sont relativement faibles et par conséquent la puissance correspondante est également faible. La puissance que permet de dissiper le condensateur de protection 113 est déterminée en fonction des courants d'harmoniques prévus.

Ainsi, pour un appareil électrique fonctionnant en courant continu, la première liaison électrique associée (qui relie le châssis de cet appareil électrique à la terre) comporte une résistance de protection 111 et un condensateur de protection 113 en parallèle. Comme déjà mentionné plus haut, en cas de défaut d'isolement, la résistance de protection 111 écoule à la terre la composante continue du courant de défaut, et le condensateur de protection 113 laisse passer et écoule à la terre la ou les composantes alternatives du courant (« courants d'harmoniques »).

Comme illustré sur la Fig. 1, lorsque le circuit électrique 10 comporte au moins un câble blindé 161, le système de protection électrique 100 comporte en outre une première liaison électrique 11 pour chaque câble blindé 161. La première liaison électrique 11 en question relie ainsi le blindage 162 du câble blindé 161 à la terre 14 et comporte la résistance de protection 111 et le condensateur de protection 113, montés en parallèle.

Le système de protection électrique 100 comporte en outre une deuxième liaison électrique 12 reliant immédiatement un point neutre (i.e. une référence de tension à 0V) du générateur G, à la terre 14. Dit autrement, la deuxième liaison électrique 12 ne comporte aucune impédance placée de manière intentionnelle. Ainsi, la deuxième liaison électrique 12 comporte seulement une impédance inévitable constituée par l'impédance d'un fil électrique assurant ladite deuxième liaison électrique 12, par un contact entre ledit fil électrique et la terre 14 et par un contact entre ledit fil électrique et le point neutre du générateur.

Ainsi, le système de protection électrique 100 peut supporter plusieurs défauts d'isolement survenant chacun dans un appareil électrique 15 (ou un câble blindé 161) distinct du circuit électrique 10, puisque le chemin passant par deux défauts d'isolement comprend alors deux résistances de protection 111, chacune associée à l'appareil électrique 15 où est situé chacun des défauts d'isolement, et est alors plus impédant que le chemin passant par le point neutre du générateur G, comprenant une seule résistance de protection 111, pour chaque défaut d'isolement.

Le système de protection électrique 100 comporte en outre au moins un détecteur de tension 112 tel qu'un voltmètre. Chaque détecteur de tension 112 est associé à un appareil électrique 15 de la pluralité d'appareils électriques 15 ou à un câble blindé 161. Le détecteur de tension 112 est configuré pour effectuer une mesure de tension aux bornes de la résistance de protection 111 de la première liaison électrique 11 associée à l'appareil électrique 15 considéré, respectivement au câble blindé 161 considéré.

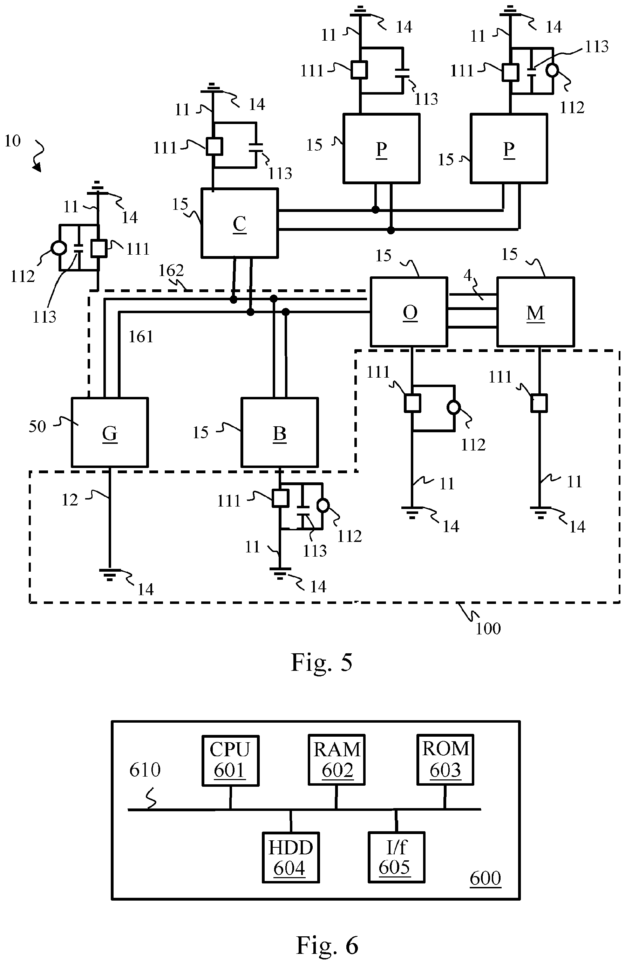

Le système de protection électrique 100 comporte en outre un contrôleur de défauts 600 (représenté en Fig. 6), configuré pour communiquer avec chaque détecteur de tension 112 et pour comparer la tension mesurée avec un seuil de tension prédéfini. Selon un exemple, le seuil de tension prédéfini est égal à la valeur de la résistance de protection 111 que multiplie un seuil de courant prédéfini, le seuil de courant prédéfini étant décrit ci-après.

Lorsque la tension mesurée dépasse le seuil de tension prédéfini, le contrôleur de défauts 600 détermine alors qu'un défaut d'isolement est présent dans le circuit électrique 10, au niveau de l'appareil électrique 15, respectivement du câble blindé 161, associé au détecteur de tension 112. En effet, tant qu'il n'y a pas de défaut d'isolement au niveau de l'appareil électrique 15, respectivement du câble blindé 161, le courant circulant entre le châssis 24 de l'appareil électrique 15, respectivement le blindage 162, et la terre 14 est faible et la tension aux bornes de la résistance de protection 111 est par conséquent faible. En revanche, lorsqu'un défaut d'isolement survient, la résistance de protection 111 se retrouve connectée entre l'une des bornes du générateur G et la terre 14, causant une augmentation de la différence de potentiel aux bornes de ladite résistance de protection 111. Un défaut d'isolement au niveau d'un appareil électrique 15 s'entend ici par un défaut d'isolement survenant dans ou autour de l'appareil électrique 15, autrement dit lorsque le châssis 24 dudit appareil électrique 15 est en contact avec une liaison électrique reliée au générateur G, que ladite liaison électrique se trouve à l'extérieur ou à l'intérieur de l'appareil électrique 15. Un défaut d'isolement au niveau d'un câble blindé 161 est défini similairement.

Avantageusement, le système de protection électrique 100 comporte un détecteur de courant 122 tel qu'un ampèremètre situé sur la deuxième liaison électrique 12, configuré pour détecter le courant circulant à travers la deuxième liaison électrique 12. Le contrôleur de défauts 600 est alors configuré pour communiquer avec le détecteur de courant 122 et pour comparer le courant mesuré avec un seuil de courant prédéfini. Selon un exemple, le seuil de courant prédéfini est égal à 0,01 A. Selon un autre exemple, le seuil de courant prédéfini est égal à 0,001 A.

Lorsque le courant mesuré dépasse le seuil de courant prédéfini, le contrôleur de défauts 600 détermine alors qu'un défaut d'isolement est présent dans le circuit électrique 10. En effet, tant qu'il n'y a pas de défaut d'isolement dans le circuit 10, le courant circulant dans la deuxième liaison électrique 12 est faible. En revanche, lorsqu'un défaut d'isolement survient dans le circuit électrique 10, le courant circulant dans la deuxième liaison électrique 12 est plus élevé puisqu'il augmente en raison d'une augmentation de la différence de potentiel entre la terre 14 et le point neutre du générateur G.

Ainsi, il est possible avec le contrôleur de défauts 600 de localiser aisément un défaut d'isolement survenant dans le circuit électrique 10, ce qui facilite la gestion de la maintenance.

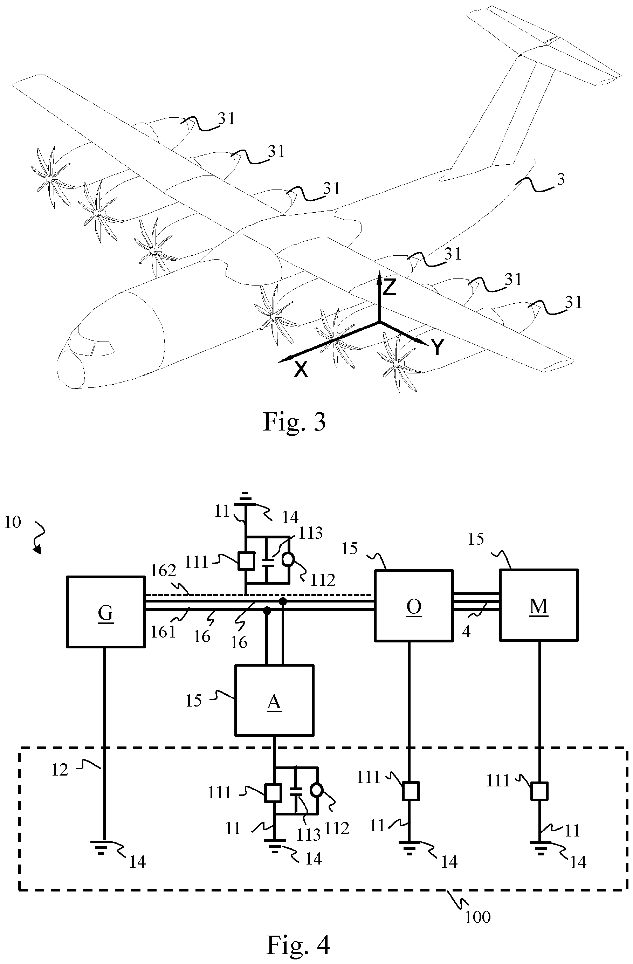

La Fig. 3 illustre schématiquement un aéronef 3 qui comporte au moins un circuit électrique 10 comportant le système de protection électrique 100. Notons que pour tout circuit électrique 10 de l'aéronef 3, la terre 14 ne correspond pas à la terre telle que définie habituellement par la masse conductrice du sol mais correspond à une référence de potentiel prédéfinie, ledit potentiel étant censé être nul dans des conditions idéales de fonctionnement. Dans l'aéronef 3, la terre 14 telle que définie dans l'invention est par exemple une coque de l'aéronef 3.

Selon un exemple de réalisation, l'aéronef 3 comporte des nacelles (« pods » en anglais) 31 et chaque nacelle 31 comporte au moins un circuit électrique 10 comportant le système de protection électrique 100. Selon cet exemple, la terre 14 est une coque de la nacelle 31.

La Fig. 4 illustre schématiquement le circuit électrique 10 comportant le système de protection électrique 100, selon un deuxième mode de réalisation.

Selon ledit deuxième mode de réalisation, le générateur G est une source d'alimentation configurée pour générer un courant continu à ses bornes. Préférentiellement, le générateur G est un ensemble de piles à combustible.

La pluralité d'appareils électriques 15 du circuit électrique 10 comporte un appareil A fonctionnant en courant continu et relié directement aux bornes du générateur G par des liaisons d'alimentation 16. La première liaison électrique associée à l'appareil A (qui relie le châssis de cet appareil A à la terre) comporte une résistance de protection 111 et un condensateur de protection 113 en parallèle.

En outre, la pluralité d'appareils électriques 15 du circuit électrique 10 comporte au moins un moteur M fonctionnant en courant alternatif et comporte un onduleur O situé entre le générateur G et ledit moteur M. Selon un exemple de réalisation, le moteur M est alimenté par trois phases 4 de courant alternatif issues de l'onduleur O.

Dans un mode de réalisation particulier, du fait que le moteur M est un appareil électrique 15 qui fonctionne en courant alternatif, la première liaison électrique 11 associée au moteur M (qui relie le châssis de ce moteur à la terre) comporte uniquement une résistance de protection 111, sans condensateur de protection en parallèle.

Lorsqu'un défaut d'isolement survient entre une liaison électrique dans laquelle circule un signal alternatif (par exemple une des phases 4 du moteur M) et le châssis 24 d'un premier appareil électrique 15 (par exemple le châssis du moteur M), il en résulte une tension alternative entre ledit châssis 24 et la terre 14. La résistance de protection 111 associée audit premier appareil électrique 15 (moteur M dans l'exemple précité) permet alors de limiter le courant circulant par la terre 14 de manière inversement proportionnelle à la valeur de la résistance de protection 111.

Par exemple, lorsque les bornes du générateur G ont des potentiels respectifs de 400 V et - 400 V, et que la tension alternative d'alimentation du moteur M est de 270V (valeur crête), la valeur de la résistance de protection 111 est de 10 kΩ. En cas de défaut d'isolement au niveau du moteur M, entre une phase 4 et le châssis 24 du moteur M, le courant de défaut alternatif circulant par la terre 14 est de 0,028 A (valeur crête). En cas de défaut d'isolement au niveau de l'appareil A, le courant de défaut continu circulant par la terre 14 est de 0,04 A.

Une capacité de filtrage 22 située sur un deuxième appareil électrique 15 du circuit électrique 10 (par exemple l'appareil A implémenté sous la forme du troisième mode de réalisation de la Fig. 2C) voit ainsi une tension suffisamment faible à ses bornes pour ne pas être détériorée par la présence du défaut d'isolement au niveau du deuxième appareil électrique 15 (par exemple l'appareil A).

La Fig. 5 illustre schématiquement le circuit électrique 10 comportant le système de protection électrique 100, selon un troisième mode de réalisation.

Selon ledit troisième mode de réalisation, le générateur G est un ensemble de piles à combustible capable de fournir un courant continu. La pluralité d'appareils électriques 15 comporte le moteur M et l'onduleur O situé entre le moteur M et le générateur G.

Dans un mode de réalisation particulier, du fait que le moteur M est un appareil électrique 15 qui fonctionne en courant alternatif, la première liaison électrique 11 associée au moteur M (qui relie le châssis de ce moteur à la terre) comporte uniquement une résistance de protection 111, sans condensateur de protection en parallèle.

La pluralité d'appareils électriques 15 comporte en outre un convertisseur C continu-continu reliant le générateur G à des pompes P de la pluralité d'appareils électriques 15. Les pompes P permettent par exemple de faire circuler des fluides, tels que des fluides caloporteurs, afin de réguler thermiquement des équipements, ou d'acheminer des fluides tels que du dihydrogène ou du dioxygène consommés par les piles à combustible du générateur G pour générer de l'énergie électrique.

Dans un mode de réalisation particulier, du fait que le convertisseur C est un appareil électrique 15 qui fonctionne en courant continu, la première liaison électrique 11 associée au convertisseur C (qui relie le châssis de ce convertisseur C à la terre) comporte une résistance de protection 111 et un condensateur de protection 113 en parallèle.

En outre, du fait que chacune des pompes P est un appareil électrique 15 qui fonctionne en courant continu, la première liaison électrique 11 associée à chaque pompe P (qui relie le châssis de cette pompe P à la terre) comporte une résistance de protection 111 et un condensateur de protection 113 en parallèle.

En outre, la pluralité d'appareils électriques 15 comporte un tampon électrique B (pour « Buffer » en anglais) comportant un condensateur ou un ensemble de condensateurs capable d'emmagasiner une quantité d'énergie prédéfinie. Lorsque le moteur M requiert une augmentation de puissance en un temps trop court par rapport à la vitesse de réaction du générateur G, par exemple lors du décollage, le tampon électrique B peut ainsi délivrer dans le temps court ladite quantité d'énergie prédéfinie emmagasinée afin de compenser la vitesse de réaction du générateur G.

Dans un mode de réalisation particulier, du fait que le tampon électrique B est un appareil électrique 15 qui fonctionne en courant continu, la première liaison électrique 11 associée au tampon électrique B (qui relie le châssis de ce tampon électrique B à la terre) comporte une résistance de protection 111 et un condensateur de protection 113 en parallèle.

La Fig. 6 illustre schématiquement un exemple de plateforme matérielle permettant d'implémenter, sous forme de circuiterie électronique, le contrôleur de défauts 600.

La plateforme matérielle comporte, reliés par un bus de communication 710 : un processeur ou CPU (« Central Processing Unit » en anglais) 601 ; une mémoire vive RAM (« Read-Only Memory » en anglais) 602 ; une mémoire morte 603, par exemple de type ROM (« Read Only Memory » en anglais) ou EEPROM (« Electrically-Erasable Programmable ROM » en anglais), telle qu'une mémoire Flash ; une unité de stockage, telle qu'un disque dur HDD (« Hard Disk Drive » en anglais) 604, ou un lecteur de support de stockage, tel qu'un lecteur de cartes SD (« Secure Digital » en anglais) ; et un gestionnaire d'interfaces I/f 605.

Le gestionnaire d'interfaces I/f 605 permet au contrôleur de défauts d'interagir avec le détecteur de courant 122 du système de protection électrique 100 et avec chaque détecteur de tension 112 associé à un appareil électrique 15 ou un câble blindé 161. Le gestionnaire d'interfaces I/f 605 permet en outre au contrôleur de défauts d'interagir avec un afficheur et/ou un dispositif de gestion de la maintenance de l'aéronef 3.

Le processeur 601 est capable d'exécuter des instructions chargées dans la mémoire vive 402 à partir de la mémoire morte 603, d'une mémoire externe, d'un support de stockage (tel qu'une carte SD), ou d'un réseau de communication. Lorsque la plateforme matérielle est mise sous tension, le processeur 601 est capable de lire de la mémoire vive 602 des instructions et de les exécuter. Ces instructions forment un programme d'ordinateur causant l'implémentation, par le processeur 601, de tout ou partie des étapes et procédés décrits ici en lien avec le contrôleur de défauts.

Tout ou partie des étapes, procédés et fonctionnements décrits ici en lien avec le contrôleur de défauts peut ainsi être implémenté sous forme logicielle par exécution d'un ensemble d'instructions par une machine programmable, par exemple un processeur de type DSP (« Digital Signal Processor » en anglais) ou un microcontrôleur, ou être implémenté sous forme matérielle par une machine ou un composant électronique (« chip » en anglais) dédié ou un ensemble de composants électroniques (« chipset » en anglais) dédié, par exemple un composant FPGA (« Field Programmable Gate Array » en anglais) ou ASIC (« Application Spécifie Integrated Circuit » en anglais). D'une manière générale, le contrôleur de défauts comporte de la circuiterie électronique adaptée et configurée pour implémenter les procédés et étapes décrits ici.

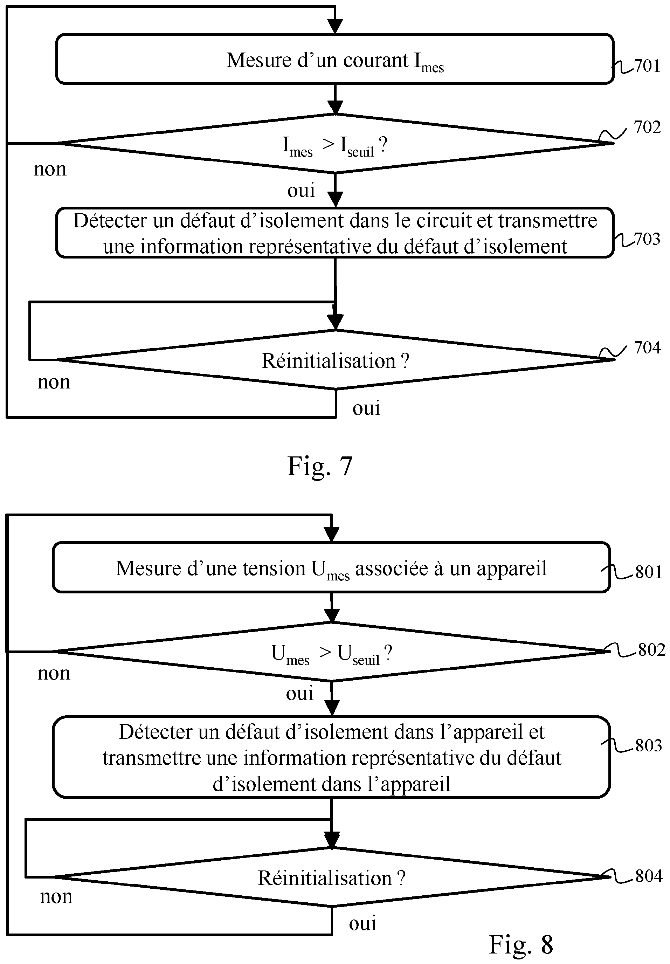

La Fig. 7 illustre schématiquement un procédé, selon un premier mode de réalisation, de détection d'un défaut d'isolement dans le circuit électrique 10. Le procédé est implémenté par le contrôleur de défauts 600 du système de protection électrique 100.

Dans une étape 701, le contrôleur de défauts 600 récupère une mesure d'un courant circulant dans la deuxième liaison électrique 12, en provenance du détecteur de courant 122. Selon un exemple, le détecteur de courant 122 peut mesurer périodiquement le courant circulant dans la deuxième liaison électrique 12 et envoyer chaque mesure au contrôleur de défauts 600 dès que la mesure est effectuée. Alternativement, le contrôleur de défauts 600 transmet un ordre de mesure au détecteur de courant 122 qui transmet la mesure de courant en réponse.

Dans une étape 702 suivante, le contrôleur de défauts 600 compare la mesure de courant reçue au seuil de courant prédéfini. Tant que la mesure de courant reste inférieure ou égale au seuil de courant prédéfini, le contrôleur de défauts 600 retourne à l'étape 701, éventuellement après l'écoulement d'un délai prédéfini. Si la mesure de courant dépasse le seuil de courant prédéfini, le contrôleur de défauts 600 passe à une étape 703.

A l'étape 703, le contrôleur de défauts 600 détermine qu'un défaut d'isolement est présent dans le circuit électrique 10.

Le contrôleur de défauts 600 transmet une information représentative de la présence d'un défaut d'isolement dans le circuit électrique 10, à l'afficheur, visible par exemple par un pilote de l'aéronef 3, et/ou au dispositif de gestion de la maintenance de l'aéronef 3. Ainsi, le pilote est informé d'un défaut d'isolement et peut décider ou non d'arrêter le générateur G. Le dispositif de gestion de la maintenance de l'aéronef 3 peut ainsi déclencher ou planifier une opération de maintenance dans le circuit électrique 10.

Dans une étape 704 suivante, le contrôleur de défauts 600 détermine si une réinitialisation est effectuée. Une réinitialisation est effectuée par exemple par un appui sur un bouton dédié lorsqu'une maintenance a été effectuée sur un défaut d'isolement. Si c'est le cas, le contrôleur de défauts 600 transmet une information représentative d'une absence de défaut d'isolement au niveau de l'appareil électrique 15 ou du câble blindé 161 considéré puis retourne à l'étape 701. Sinon, le contrôleur de défauts 600 reste à l'étape 704.

La Fig. 8 illustre schématiquement un procédé, selon un deuxième mode de réalisation, de détection d'un défaut d'isolement dans le circuit électrique 10. Le procédé est implémenté par le contrôleur de défauts 600 du système de protection électrique 100.

Dans une étape 801, le contrôleur de défauts 600 récupère une mesure d'une tension aux bornes d'une résistance de protection 111 en provenance du détecteur de tension 112 associé à un appareil électrique 15 ou à un câble blindé 161. Selon un exemple, le détecteur de tension 112 peut mesurer périodiquement ladite tension et envoyer chaque mesure au contrôleur de défauts 600 dès que la mesure est effectuée. Alternativement, le contrôleur de défauts 600 transmet un ordre de mesure au détecteur de tension 112 qui transmet la mesure de tension en réponse. Selon un mode de réalisation particulier, la mesure de tension est reçue en association avec un identifiant de l'appareil électrique 15 ou du câble blindé 161 associé au détecteur de tension 112.

Dans une étape 802 suivante, le contrôleur de défauts 600 compare la mesure de tension reçue au seuil de tension prédéfini. Tant que la mesure de tension reste inférieure ou égale au seuil de tension prédéfini, le contrôleur de défauts 600 retourne à l'étape 801, éventuellement après l'écoulement d'un délai prédéfini. Si la mesure de tension dépasse le seuil de tension prédéfini, le contrôleur de défauts 600 passe à une étape 803.

A l'étape 803, le contrôleur de défauts 600 détermine qu'un défaut d'isolement est présent dans le circuit électrique 10, au niveau de l'appareil électrique 15 ou du câble blindé 161 associé au détecteur de tension 112 considéré.

Le contrôleur de défauts 600 transmet alors une information représentative de la présence d'un défaut d'isolement au niveau de l'appareil électrique 15 ou du câble blindé 161 considéré, à l'afficheur, visible par exemple par un pilote de l'aéronef 3, et/ou au dispositif de gestion de la maintenance de l'aéronef 3. Ainsi, le pilote est informé d'un défaut d'isolement et peut décider ou non d'arrêter le générateur G en tenant compte de l'emplacement dudit défaut d'isolement. Le dispositif de gestion de la maintenance de l'aéronef 3 peut ainsi déclencher ou planifier une opération de maintenance visant à remplacer l'appareil électrique 15 ou le câble blindé 161 concerné.

Dans une étape 804 suivante, le contrôleur de défauts 600 détermine si une réinitialisation est effectuée. Une réinitialisation est effectuée par exemple par un appui sur un bouton dédié lorsqu'une maintenance a été effectuée sur le défaut d'isolement détecté, au niveau de l'appareil électrique 15 ou du câble blindé 161 considéré. Si c'est le cas, le contrôleur de défauts 600 transmet une information représentative d'une absence de défaut d'isolement au niveau de l'appareil électrique 15 ou du câble blindé 161 considéré puis retourne à l'étape 801. Sinon, le contrôleur de défauts 600 reste à l'étape 804.

Le procédé de détection de défauts d'isolement selon le premier mode de réalisation et le procédé de détection de défauts d'isolement selon le deuxième mode de réalisation peuvent être implémentés par le contrôleur de défauts 600 indépendamment l'un de l'autre, de manière sélective ou en parallèle.

## Revendications

1. Système de protection électrique (100) d'un circuit électrique (10) d'un aéronef, le circuit électrique (10) comportant :
- un générateur (G), et
- une pluralité d'appareils électriques (15), chaque appareil électrique (15) comportant un châssis (24),
le système de protection électrique (100) étant **caractérisé en ce qu'**il comporte :
- une première liaison électrique (11) associée à chaque appareil électrique (15), chaque première liaison électrique (11) reliant le châssis (24) dudit appareil électrique (15) à une terre (14), chaque première liaison électrique (11) comportant une résistance, dite résistance de protection (111), et
- une deuxième liaison électrique (12) reliant un point neutre du générateur (G) à la terre (14),
et **en ce que**, pour au moins un des appareils électriques (15) fonctionnant en courant continu, la première liaison électrique (11) associée comporte un condensateur (113), dit condensateur de protection, en parallèle de la résistance de protection (111).

2. Système de protection électrique (100) selon la revendication 1, dans lequel, pour au moins un des appareils électriques (15) fonctionnant en courant alternatif, la première liaison électrique (11) associée comporte uniquement la résistance de protection (111), sans condensateur de protection en parallèle.

3. Système de protection électrique (100) selon l'une des revendications 1 et 2, dans lequel le circuit électrique (10) comporte en outre au moins un câble blindé (161) comportant un blindage (162) et reliant au moins un appareil électrique (15) aux bornes du générateur (G),
et dans lequel le système de protection électrique (100) comporte en outre une première liaison électrique (11) associée à chaque câble blindé (161), ladite première liaison électrique (11) reliant le blindage (162) du câble blindé (161) à la terre (14) et comportant une résistance de protection (111) et un condensateur de protection (113) en parallèle de la résistance de protection (111).

4. Système de protection électrique (100) selon l'une des revendications 1 à 3, comportant en outre :
- au moins un détecteur de tension (112), chaque détecteur de tension (112) étant associé à une première liaison électrique (11) et étant configuré pour effectuer une mesure de tension aux bornes de la résistance de protection (111) de ladite première liaison électrique (11), et
- un contrôleur de défauts (600) configuré, pour chaque détecteur de tension (112), pour :
∘ recevoir une mesure de tension en provenance du détecteur de tension (112), et
∘ transmettre une information représentative d'un défaut d'isolement sur l'appareil électrique (15) associé à la première liaison électrique (11) qui est associée au détecteur de tension (112) lorsque la mesure de tension dépasse un seuil de tension prédéfini.

5. Système de protection électrique (100) selon la revendication 4, comportant en outre un détecteur de courant (122) configuré pour effectuer une mesure de courant circulant par la deuxième liaison électrique (12),
et dans lequel le contrôleur de défauts (600) est configuré en outre pour :
- recevoir la mesure de courant en provenance du détecteur de courant (122), et
- transmettre une information représentative d'un défaut d'isolement dans le circuit électrique (10) lorsque la mesure de courant dépasse un seuil de courant prédéfini.

6. Système de protection électrique (100) selon l'une quelconque des revendications 1 à 5, dans lequel chaque résistance de protection (111) a une valeur comprise entre 1 kΩ et 10 kΩ.

7. Système de protection électrique (100) selon l'une quelconque des revendications 1 à 6, dans lequel le générateur (G) génère un courant continu et dans lequel la pluralité d'appareils comporte au moins un moteur (M) fonctionnant en courant alternatif et un onduleur (O) situé entre le générateur (G) et ledit moteur (M).

8. Système de protection électrique (100) selon l'une quelconque des revendications 1 à 7, dans lequel le générateur (G) est un ensemble de piles à combustible.

9. Aéronef comportant un système de protection électrique (100) selon l'une quelconque des revendications 1 à 8.

10. Procédé destiné à détecter un défaut d'isolement dans un circuit électrique (10), le circuit électrique (10) comportant :
- un générateur (G),
- une pluralité d'appareils électriques, chaque appareil électrique comportant un châssis (24), et
- un système de protection électrique (100) comportant :
∘ une première liaison électrique (11) associée à chaque appareil électrique (15), chaque première liaison électrique (11) reliant le châssis (24) dudit appareil électrique (15) à une terre (14), chaque première liaison électrique (11) comportant une résistance, dite résistance de protection (111) ; pour au moins un des appareils électriques (15) fonctionnant en courant continu, la première liaison électrique (11) associée comporte un condensateur (113), dit condensateur de protection, en parallèle de la résistance de protection (111) ;
∘ une deuxième liaison électrique (11) reliant immédiatement un point neutre du générateur (G) à la terre (14), et
∘ au moins un détecteur de tension (112), chaque détecteur de tension (112) étant associé à une première liaison électrique (11) et étant configuré pour effectuer une mesure de tension aux bornes de la résistance de protection (111) de la première liaison électrique (11),
le procédé étant implémenté par un contrôleur de défauts (600) et comportant, pour chaque détecteur de tension (112), des étapes de :
- recevoir (701) une mesure de tension en provenance du détecteur de tension (112), et
- transmettre (703) une information représentative d'un défaut d'isolement sur l'appareil électrique (15) associé à la première liaison électrique (11) qui est associée au détecteur de tension (112) lorsque la mesure de tension dépasse un seuil de tension prédéfini.

11. Procédé selon la revendication 10, dans lequel le système de protection électrique (100) comporte en outre un détecteur de courant (122) configuré pour effectuer une mesure de courant circulant par la deuxième liaison électrique (12), le procédé comportant en outre des étapes de :
- recevoir (801) la mesure de courant en provenance du détecteur de courant (122), et
- transmettre (803) une information représentative d'un défaut d'isolement dans le circuit électrique (10) lorsque la mesure de courant dépasse un seuil de courant prédéfini.
